Europäisches Patentamt

(19) European Patent Office

Office européen des brevets

(11) Publication number: **0 005 125**
A1

## (12) EUROPEAN PATENT APPLICATION

(21) Application number: 79830003.4

(22) Date of filing: 01.03.79

(51) Int. Cl.²: **H 01 L 21/285**
H 01 L 21/31, H 01 L 21/28
H 01 L 29/80

(30) Priority: 09.03.78 IT 4836878

(43) Date of publication of application:
31.10.79 Bulletin 79/22

(84) Designated Contracting States:
DE FR GB

(71) Applicant: SELENIA INDUSTRIE ELETTRONICHE
ASSOCIATE S.p.A.
Via Tiburtina, KM 12.4
I-00131 Roma(IT)

(72) Inventor: Buiatti, Marina
Via Grossi Gondi, 62
I-00100 Roma(IT)

(72) Inventor: Misiano, Carlo
Via Morgagni, 22
I-00100 Roma(IT)

(54) Method for manufacturing contacts on semiconductor devices and devices made by this method.

(57) The present invention complements a previous invention on a self-aligned process for MESFET transistors. After the gate electrode (11) is defined, leaving a very fine gap in between the ohmic (12) and the gate contacts, the different etch rate of the two contacts with respect to ion etching is exploited in order to increase the separation in the pad region.

fig. 2

Improvement in a method for manufacturing Semiconductor devices

D E S C R I P T I O N

The present invention relates to an improvement in manufacturing semiconductor devices. In the United States Patent No. 4, 045, 712 by the same
inventor, a process is described for manufacturing MES-FET transistors
with self-aligned Schottky barrier gate electrodes.

Once the gate electrode is fabricated with the process described in the abo
ve mentioned patent, the problem arises of defining the geometry of the
ohmic contacts representing the Source and Drain contacts.

The geometrical definition of such contacts, generally made by layers of
Au, Ge, NiCr or an alloy of Au and Ge, is not trivial insofar as the materials forming the ohmic contacts can not be easily etched by wet chemistry while the gate electrode, made of Al, can be very easily etched.

The present invention relates to a process whereby the geometry of the abo
ve mentioned ohmic contacts is shaped without any appreciable damage to the
gate electrode previously defined.

The present invention makes use of ion milling or sputter etching and exploits
the relatively high ratio between the etching rate of the material forming
the ohmic contacts (tipically Au-Ge) and the material forming the gate elec
trode (tipically Al), relative to ion etching.

Again, according to this invention, such ratio of the etching rates can be
increased by the addition of reactive gases to the armosphere of the etching chamber (e.g. oxygen in the case of Al vs. Au).

The present invention will be now described in connection with a preferred
enbodiement with reference to the enclosed drawings. However it will be
understood that such description is only meant as an illustrative but not
limitative example.

Figure 1 and 1a show respectively a view from the top and a cross section of a tipical semiconductor device to be processed according to this invention. Figure 2 and 2a show, respectively, a view from the top and a cross section of the device at an intermediate stage in processing according to this invention.

Figure 3 and 3a show, respectively, a view from the top and a cross section of the device after the process is completed according to this invention.

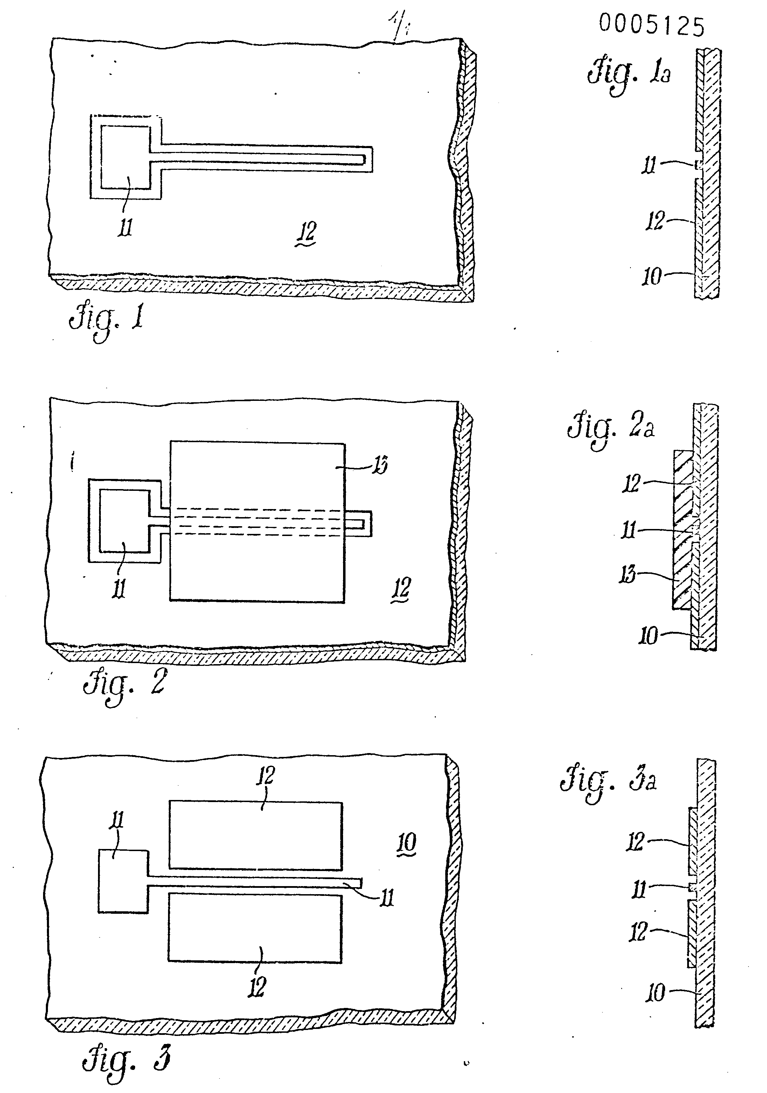

With reference to fig. 1 and 1a the device is shown at a given stage in its fabrication process; the semiconductor wafer e.g. GaAs is shown after a gate electrode, made e.g. of aluminum, has been defined e.g. according to the process described in U.S. patent No. 4, 048, 712. The gate electrode 11 is surrounded by an ohmic contact metallization 12, made e.g. of Au-Ge, which must be selectively etched in order to define two separate areas, constituting the source and drain electrodes, when this process is performed in the fabrication of a F.E.T.

Next, with reference to fig. 2 and 2a, a layer of masking material (e.g. photoresist of suitable thickness) 13 is deposited over the portion of ohmic contact to be preserved, as well as a portion of the gate electrode. The wafer is then processed by ion etching, plasma etching, R.F. or D.C. sputtering in such a way as to remove the portion od ohmic contact which is not protected by the masking material 13.

During this etching process the ohmic metallization 12 is preferentially etched with respect to the gate metallization 13 because of the different etching rate of Al vs. Au-Ge. Actually, especially in presence of an oxidizing atmosphere in the etching chamber, the gate electrode is almost unaffected by the etching process.

The process according to this invention allows a definition of the ohmic contacts without chemical etching. Selective chemical etching would not be easy considering the nature of the materials in question and masking selectively the gate electrode would require a very critical aligning step due to the geometries tipical of semiconductor devices, in particular the channel region of a F.E.T.

Also this invention allows one to electroplate gold onto the source and drain contacts before the etching is performed, because of the electrical continu tv of the ohmic metallization before etching. This compares to the procedure generally used where the gate electrode is initially defined as surrounding the source and drain areas (rather than viceversa as in Fig. 1). In this case the definition of the gate electrode by chemical etching becomes easy (because it requires selectively etching Al with respect to Au) but one can not electroplate the gold because of a lack of electrical continuity.

Finally we wish to mention that one can use to some advantage a metallic or dielectric layer defined e.g. by lifting, instead than photoresist, as masking material in the etching process (No. 13 of fig. 2, 2a).

CLAIMS
======

1. A method of defining the second contact in a semiconductor structure com prising at least one first contact with a well defined geometry and a second contact with yet undefined geometry being such method characterized by the use of ion etching in the definition of the second contact mentio ned above and by the fact that the first contact,already defined,is made of a material relatively unsensitive to ion, sputter or plasma etching while the second contact is made of a highly sensitive material, or that such difference in etching rate can be obtained by the choice of a suitable atmosphere.

2. A process as claimed in 1, wherein  the first contact with defined geometry is the gate electrode of a GaAs FET, and the second contact comprises the source and drain electrodes.

3. A process as claimed in 1 or 2 wherein the geometry of the second electrode is defined by a photoresist mask.

4. A process as claimed in 1, 2 or 3, wherein the geometry of the second contact is defined by a metallic or dielectric mask obtained by "lifting".

5. A process as claimed in one or more of the previous claims, wherein the etching process is performed by D.C. or R.F. sputtering or ion beam or plasma etching.

6. A process as claimed in one or more of the previous claims, wherein the first contact is made of aluminum and the second contact is made of an ohmic contact of one or more of the following materials: Au, Ge, NiCr,Ni.

7. A process as claimed in one or more of the previous claims, wherein the second contact is totally or selectively plated before the etching is performed.

8. A process as claimed in one or more of the previous claims, wherein a reactive gas is used during the etching process in order to enhance the difference in etching rates between the first contact and the second contact.

9. A process as claimed in 8, wherein the reactive gas is oxygen and the first contact is made of aluminum.

10. A semiconductor device, in particular a GaAs FET fabricated according to the process as claimed in one or more of the previous claims.

0005125

Fig. 1

Fig. 1a

Fig. 2

Fig. 2a

Fig. 3

Fig. 3a

## DOCUMENTS CONSIDERED TO BE RELEVANT

| Category | Citation of document with indication, where appropriate, of relevant passages | Relevant to claim |
|---|---|---|
| | Solid State Technology, vol. 9, no. 5, Aug. 1976 New York R.L. BERSIN: "A Survey of plasma-etching processes" pages 31-38.   * Table 1, page 33 *     -- | 1 |
| | US - A - 3 923 568 (R.L. BERSIN)   * Abstract, column 2, lines 47-58 *     -- | 1 |
| A | FR - A - 2 098 314 (WESTINGHOUSE)   * Claim 1 *     -- | 1,6 |
| A | US - A - 3 994 758 (NIPPON ELECTRIC COMP.)   * Column 3, lines 35-68; column 4, lines 1-58; figure 2 *     -- | 1,4,6 |
| A | TOUTE L'ELECTRONIQUE, no. 420, April 1977 Paris "Une technologie d'avenir les FET "AS-GA"" page 13   * Page 13 *     ---- | 1,4,6 |

### CLASSIFICATION OF THE APPLICATION (Int. Cl.²)

H 01 L 21/285
21/31
21/28
29/80

### TECHNICAL FIELDS SEARCHED (Int.Cl.²)

H 01 L 21/285
21/31
21/28
29/80

### CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 13-06-1979 | PELSERS |

EPO Form 1503.1   06.78